# EUROPEAN PATENT APPLICATION

(11) **EP 4 398 309 A1**
(43) Date of publication of application: **10.07.2024**
(21) Application number: 23220797.7
(22) Date of filing: 29.12.2023
(51) Int. Cl.: H01L 29/06, H01L 29/08, H01L 29/747, H01L 29/423

(54) **HIGH NOISE IMMUNITY TRIAC STRUCTURE WITH INSULATING TRENCH**

(30) Priority: 30.12.2022 CN 202211722830
(71) Applicant: Littelfuse Semiconductor (Wuxi) Co., Ltd., Wuxi, Jiangsu 214142 (CN)
(72) Inventor: ZHOU, Jifeng, Wuxi, 214142 (CN); ZHANG, Glenda, Wuxi, 214142 (CN); HE, Lei, Wuxi, 214142 (CN)
(74) Representative: Arnold & Siedsma

(57) **Abstract**

A TRIAC semiconductor includes an N- region (310), multiple N+ regions (314a-e), and a trench (326). The N- region (310) is sandwiched between two P regions (308, 312). The first P region (308) is connected to an MT2 terminal and the second P region (312) is connected to two MT1 terminals. The multiple N+ regions are located within the first P region (312). The trench (326) is located between two gate terminals (G).

## Description

### Field of the Disclosure

Embodiments of the present disclosure relate to triodes for alternating current (TRIACs) and, more particularly, to a TRIAC with high noise immunity.

### Background

Thyristors are semiconductor switches used to control the flow of electrical current. Thyristors are used in applications such as home appliances (lighting, heating, temperature control, alarm activation, fan speed), electrical tools (for controlling motor speed, stapling event, battery charging), and outdoor equipment (water sprinklers, gas engine ignition, electronic displays, area lighting, sports equipment, physical fitness).

Similar to diodes, thyristors are three-terminal devices with a PNPN configuration consisting of an anode terminal connected to a first P section, a cathode terminal connected to a second N section, and a gate terminal connected to the P section nearest the cathode. When a positive voltage is applied at the gate of the device, the thyristor turns on and will remain on, even if the gate signal is removed. If current flowing through the thyristor drops below a latch-on current level, the SCR will turn off. The thyristor conducts current only in one direction.

TRIACs (short for TRIode for Alternating Current) consist of two thyristors connected together in an inverse parallel relationship to one another. The two thyristors making up the TRIAC share a common gate terminal. Distinguishable from thyristors, TRIACs enable current to flow in both directions.

Because a very small amount of current in the gate will activate the device, both thyristors and TRIACs are sensitive to noise, as the noise may cause device mis-triggering and result in the application circuit malfunction.

It is with respect to these and other considerations that the present improvements may be useful.

### Summary

This Summary is provided to introduce a selection of concepts in a simplified form that are further described below in the Detailed Description. This Summary is not intended to identify key or essential features of the claimed subject matter, nor is it intended as an aid in determining the scope of the claimed subject matter.

An exemplary embodiment of a triode for alternating current (TRIAC) semiconductor in accordance with the present disclosure may include an N- region, multiple N+ regions, and a trench. The N- region is sandwiched between two P regions. The first P region is connected to an MT2 terminal and the second P region is connected to two MT1 terminals. The multiple N+ regions are located within the first P region. The trench is located between two gate terminals.

### Brief Description of the Drawings

**FIGs. 1A-1D** are diagrams illustrating a TRIAC, in accordance with the prior art;
**FIG.** 2 is a diagram illustrating a TRIAC, in accordance with the prior art; and
**FIGs. 3A-3B** are diagrams illustrating a TRIAC, in accordance with exemplary embodiments.

### Detailed Description

A triode for alternating current (TRIAC) semiconductor is disclosed. Following a sophisticated design in which a trench is added, the gate terminal and the MT1 terminal are each bisected into separate terminals. The trench cuts through portions of the N+ regions, through one P region, and also partly into the N- region. The effect of the trench is to divide the semiconductor into two halves, one of which operates when the bias of MT2 is higher than MT1 and the other of which operates when the bias of MT2 is lower than MT1. In addition to eliminating shunt current in the semiconductor and improving noise immunity, the novel trench-based design improves both static dv/dt and commutating performance.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

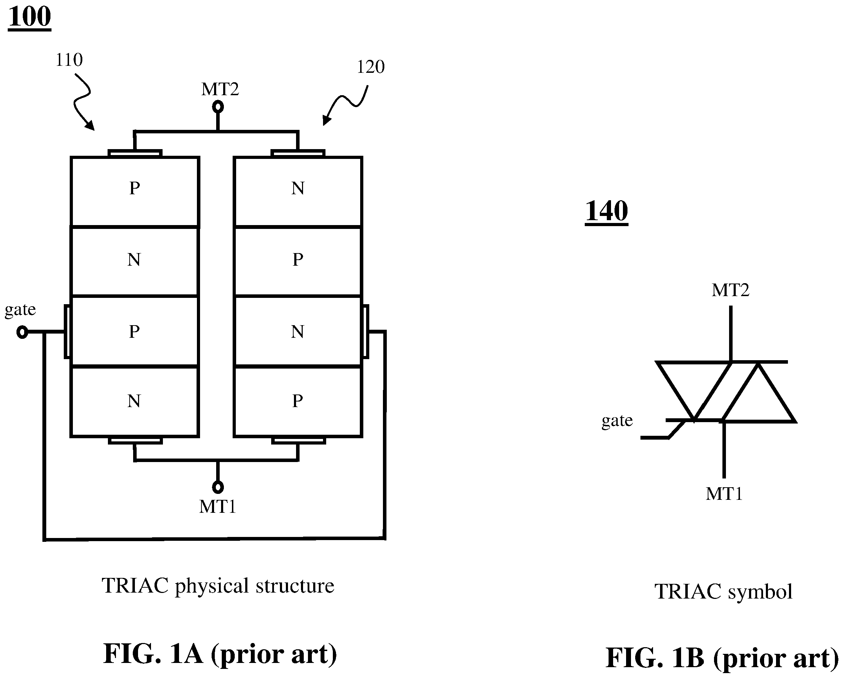

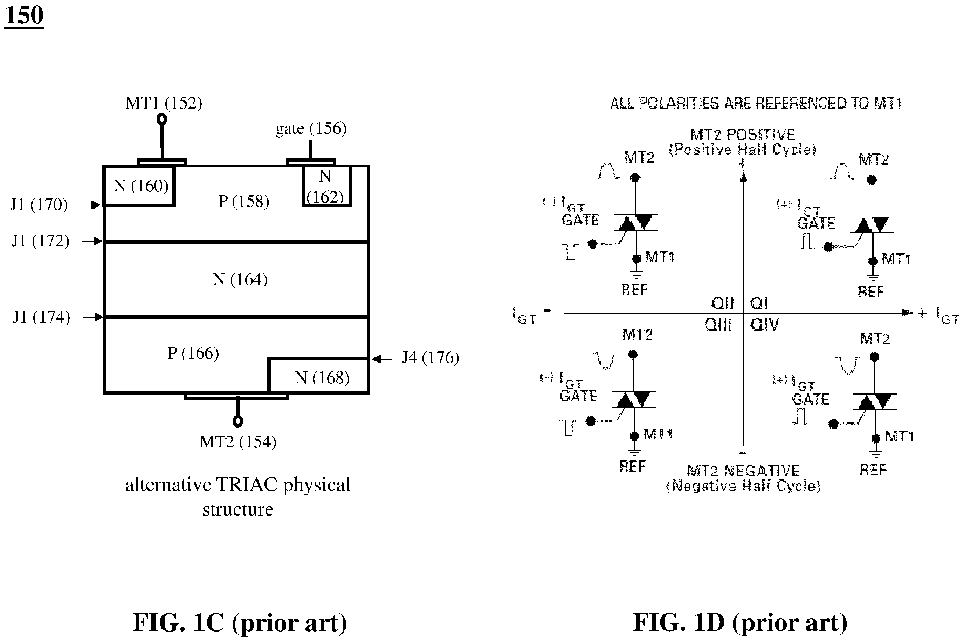

**FIGs. 1A-1D** are representative drawings of a TRIAC, according to the prior art. **FIG. 1A** shows the TRIAC 100 (physical structure), **FIG. 1B** shows the TRIAC symbol 140, **FIG. 1C** shows a sophisticated TRIAC design, and **FIG. 1D** shows TRIAC behavior in four quadrants QI, QII, QIII, and QIV. The TRIAC 100 is a solid state semiconductor device having alternating layers of P-type material and N-type material, with the P-type material being silicon or germanium material doped with an electron acceptor element and the N-type material being silicon or germanium material doped with an electron donor element. The TRIAC 100 is essentially two back-to-back thyristors 110 and 120, the first thyristor 110 having a PNPN configuration and the second thyristor 120 having an NPNP configuration, as shown.

The TRIAC 100 is a three-terminal device having an MT1 terminal coupled to a bottom P layer and a bottom N layer, an MT2 terminal coupled to a top P layer and a top N layer and a gate coupled to an inner P layer and an inner N layer. The TRIAC 100 is a bidirectional device, allowing current to flow in both directions, in contrast to the thyristor, which is a unidirectional device. TRIACs are designed to control a relatively large amount of power and voltage with a small device.

**FIG. 1C** shows a second TRIAC 150, according to the prior art. The physical structure of the TRIAC 150 is more sophisticated than that of the TRIAC 100. As before, the TRIAC 150 has alternating N and P regions, as well as an MT1 terminal 152, an MT2 terminal 154, and a gate 156. P regions 158 and 166 and N regions 160, 162, 164, and 168 are shown, with N regions 160 and 162 being embedded within P region 158 and N region 168 being embedded within P region 166. N region 164 is sandwiched between P regions 158 and 166. The MT1 terminal 152 straddles the N region 160 and the P region 158, the MT2 terminal 154 straddles the P region 166 and the N region 168, and the gate straddles the P region 158 and the N region 162.

The TRIAC 150 features four junctions 170, 172, 174, and 176. Junction 170 is between the P layer 158 and the N layer 160; junction 172 is between the N layer 164 and the P layer 158; junction 174 is between the N layer 164 and the P layer 166, and junction 176 is between the P layer 166 and the N layer 168. These junctions exhibit different behaviors based on quadrant in which the TRIAC is operating.

**FIG. 1D** shows TRIAC behavior in four quadrants, QI-QIV, according to the prior art. TRIACs thus have four operating modes, each mode corresponding to one of the quadrants. In the first mode (QI), MT2 is positive with respect to MT1 with a gate polarity positive with respect to MT1. In the second mode (QII), MT2 is positive with respect to MT1 with a gate polarity negative with respect to MT1. In the third mode (QIII), MT2 is negative with respect to MT1 with a gate polarity negative with respect to MT1. In the fourth mode (QIV), MT2 is negative with respect to MT1 with a gate polarity positive with respect to MT1.

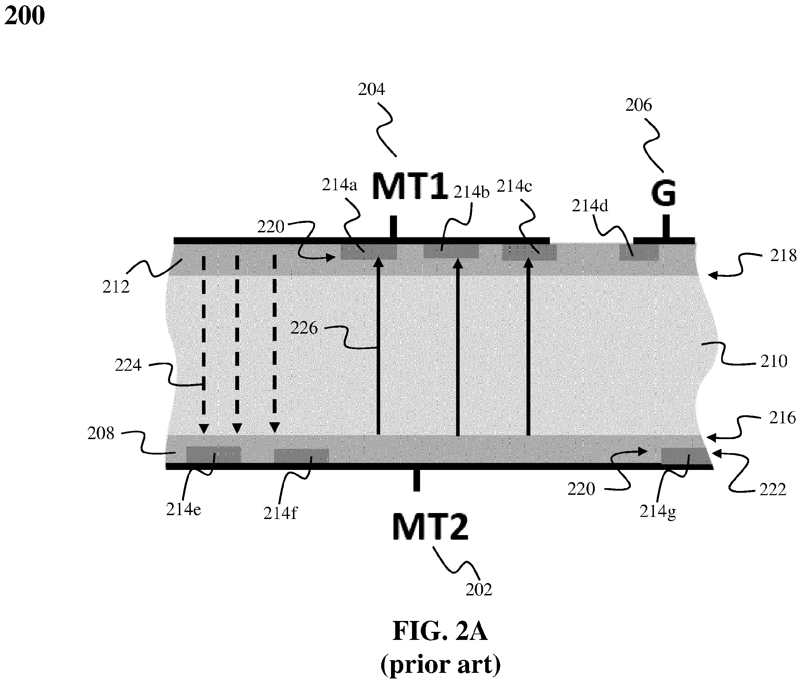

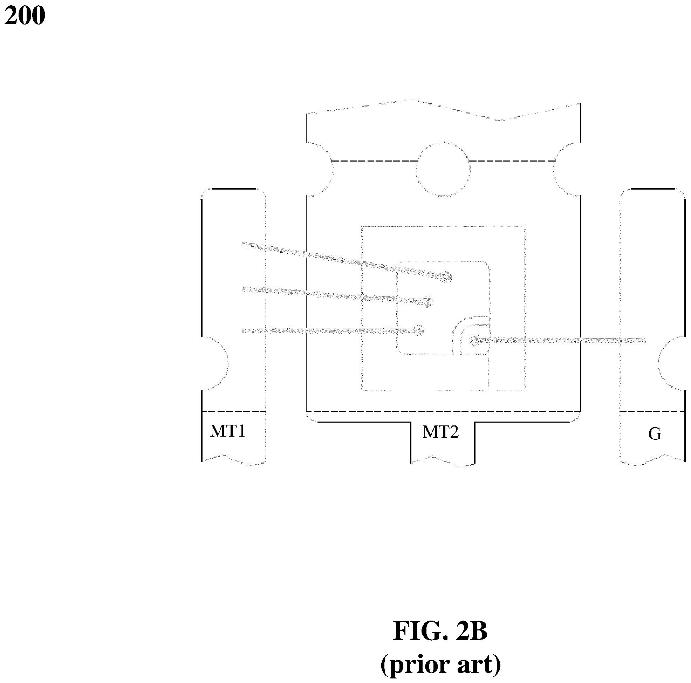

**FIGs. 2A-2B** are representative drawings of a TRIAC semiconductor 200, according to the prior art. **FIG. 2A** is a side view and **FIG. 2B** is a top view from the package side of the TRIAC semiconductor 200. Though a little different from the TRIAC 150, the TRIAC semiconductor 200 is also a sophisticated design structure with a PNPN configuration. The TRIAC semiconductor 200 features an MT2 terminal 202 connected to a P region 208, which is adjacent an N- region 210, and an MT1 terminal 204 connected to a P region 212, which is also adjacent the N- region 210. The N- region 210 is sandwiched between the two P regions 208 and 212. A final N+ region of the TRIAC semiconductor 200 consists of multiple disjointed N+ regions 214a-214g (collectively, "N+ region(s) 214"), with N+ regions 214a, 214b, 214c, and 214d being in the P region 212 and N+ regions 214e, 214f, and 214g being in the P region 208. A gate terminal 206 is connected to the second P region 212.

Like the TRIAC 150, the TRIAC semiconductor 200 features four junctions 216, 218, and 220. Junction 216 is between the P region 208 and the N- region 210; junction 218 is between the N- region 210 and the P region 212; junction 220 is between the P region 212 and the N+ regions 214a-d, and junction 222 is between the P region 208 and the N+ regions 214e-g. As with the TRIAC 100, the junctions exhibit different behaviors based on the biases between the MT1 and MT2 terminals as well as the gate polarity (see **FIG. 1D****).**

Dashed arrows 222 and solid arrows 224 denote electron/current paths. Dashed arrows 222 denote the current flow between MT1 terminal 204 and MT2 terminal 202. Solid arrows denote the current flow between MT2 terminal 202 and MT1 terminal 204. The TRIAC semiconductor 200 is triggered such that current flows between the MT2 terminal 202 and the MT1 terminal 204 by adding a positive bias on the gate terminal 206 or a negative bias on the gate terminal 206.

As with the TRIAC 100, the TRIAC semiconductor 200 is a switching device. Both the N+ region 214d and the P region 212 are located at the gate terminal 206. This allows the TRIAC semiconductor 200 to be turned on with either a negative or a positive voltage being applied. When a positive voltage is applied at the gate terminal 206, the gate cathode junction 220 will become forward biased, which allows the TRIAC semiconductor 200 to turn on. However, because of the disjointed N+ regions 214, current will flow between the disjointed N+ regions 214 and the P region 212 before the gate cathode junction 220 (N+P region) becomes forward biased. Electrons need to go through from the gate through this area because there is a resistance path without any PN junction area, which results in the occurrence of a shunt current before the gate cathode junction 220 can be forward biased.

With reference to the two-thyristor model **(****FIG. 1A****)** of the TRIAC 100, the N+ regions 214a-d, P region 212, the N region 210, and P region 208 of the TRIAC semiconductor 200 corresponds to the thyristor 120 and the P region 208, N region 210, P region 212, and N regions 214-d of the TRIAC semiconductor 200 corresponds to the thyristor 180. The connection of the two thyristors triggers the occurrence of regenerative action when a proper gate signal is applied to the base of the first NPN transistor.

The top view of the TRIAC semiconductor 200 package in **FIG. 2B** shows that the backside of the chip (left MT2) will be attached to the leadframe and connected with the center pin of the package (named MT2), MT1 of the chip will connect to the left pin of the package, and the gate of the chip will connect to the right pin of the package.

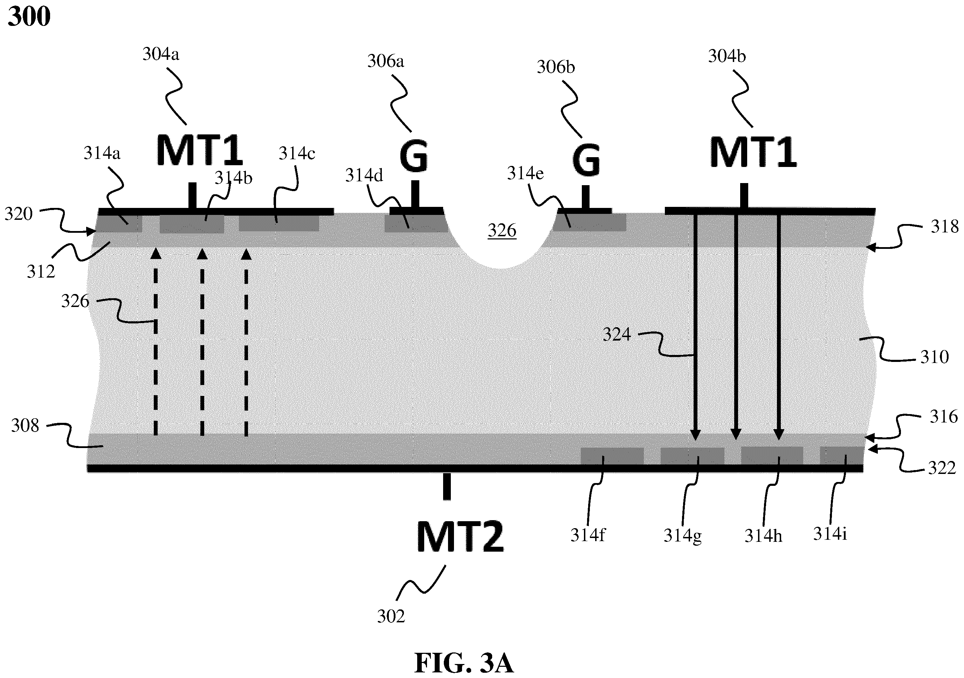

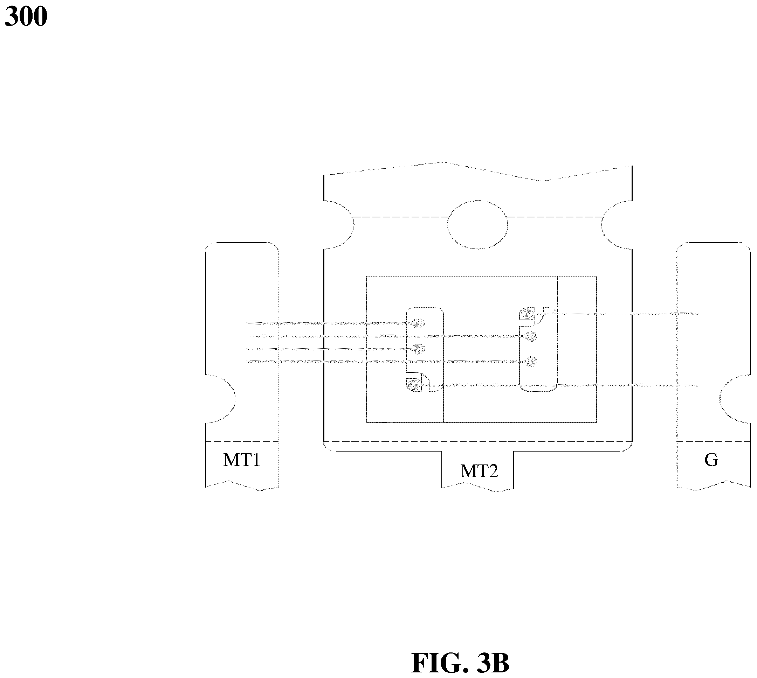

**FIGs. 3A-3B** are representative drawings of a TRIAC semiconductor 300, according to exemplary embodiments. **FIG. 3A** is a side view and **FIG. 3B** is a top view from the package side of the TRIAC semiconductor 300. In contrast to the prior art TRIAC semiconductor 200, a trench 326 isolates the TRIAC semiconductor 300 into two halves. The addition of the trench 326 makes the TRIAC semiconductor 300 operate like two transistors 180 and 190, as with the SCR 100 **(****FIG. 1B****).** The TRIAC semiconductor 300 features an MT2 terminal 302 connected to a P region 308, which is adjacent an N- region 310, and two MT1 terminals 304a and 304b, both of which are connected to a P region 312, which is also adjacent the N- region 310. The N- region 310 is sandwiched between the two P regions 308 and 312. A final N+ region of the TRIAC semiconductor 300 consists of multiple disjointed N+ regions 314a-214i (collectively, "N+ region(s) 314"), with N+ regions 314a, 314b, 314c, 314d, and 314e being in the P region 312 and N+ regions 314f, 314g, 314h, and 314i being in the P region 308. Dual gate terminals 306a and 306b are connected to the second P region 312 and disposed on either side of the trench 326.

In exemplary embodiments, the N+ region 314d is disposed beneath the gate 306a and the N+ region 314e is disposed beneath the gate 306b, with the trench 326 being between the two. In exemplary embodiments, the trench 326 passes through the P region 312 and cuts into the N-region 310. The trench 326 thus bisects three layers of the TRIAC 300, a portion of the N+ regions 314, the P region 312, and a portion of the N- region 310. In exemplary embodiments, the MT2 terminal 302 is connected to both the P region 308 and the N+ regions 314f-i while the MT1 terminal is connected to both the P region 312 and the N+ regions 314a-c.

In exemplary embodiments, the MT1 terminals 304a and 304b are connected together (by wires) in the package assembly. Similarly, in exemplary embodiments, the gate terminals 306a and 306b are connected together in the package assembly, as shown in **FIG. 3B****.**

Like the other semiconductor devices described herein, the TRIAC semiconductor 300 features four junctions 316, 318, 320, and 322. Junction 316 is between the P region 308 and the N- region 310; junction 318 is between the N- region 310 and the P region 312; junction 320 is between the P region 312 and the N+ regions 314a-e; and junction 322 is between the N+ regions 314f-i and the P region 308.

As with the TRIAC 100, the junctions exhibit different behaviors based on the voltage bias between the M1 and M2 terminals as well as the gate polarity. Dashed arrows 322 and solid arrows 324 denote current paths. Dashed arrows 322 denote the current flow between the MT2 terminal 302 and the MT1 terminal 304a. Solid arrows denote the current flow between the MT1 terminal 304b and the MT2 terminal 302. If the MT2 terminal 302 is given a positive potential with respect to the MT1 terminal 304, then junctions 316 and 320 are forward-biased while junction 318 is reverse-biased. Accordingly, current will flow from the MT2 terminal 302 to the MT1 terminal 304a, as shown by the dashed arrows 322. If on the other hand, the MT2 terminal 302 is given a negative potential with respect to the MT1 terminal 304, then junctions 316 and 320 are reverse-biased while junction 318 is forward-biased. Accordingly, current will flow from the MT1 terminal 304b to the MT2 terminal 302, as shown by the solid arrows 324.

In exemplary embodiments, the left part of the silicon of the TRIAC semiconductor 300 works if the bias of the MT2 terminal 304 is higher than that of the MT1 terminal 304 and the right part of the silicon works if the bias of the MT1 terminal 304 is higher than that of the MT2 terminal 302. In exemplary embodiments, the TRIAC 300 semiconductor can make it easier to tune Igt, at different quadrants to give much better static dv/dt, which improves the noise immunity and commutating performance. In some embodiments, the TRIAC semiconductor 300 works in quadrants II and III, but not in quadrants I and IV.

The top view of the TRIAC semiconductor 300 package in **FIG. 3B** shows that, even though there are two MT1 terminals 304a and 304b and two gates 306a and 306b, when assembled, in a non-limiting example, the two MT1 terminals 304a and 304b will be connected to the left pin by five wires and the two gate terminals 306a and 306b will be connected to the right pin by two wires, although the number of wires for each connection may be adjusted based on the current requirement. The MT2 terminal 302 is attached to the leadframe pad and is drawn out from the center pin (MT2), which is the same as for the TRIAC 200 **(****FIG. 2B****).**

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure refers to certain embodiments, numerous modifications, alterations, and changes to the described embodiments are possible without departing from the sphere and scope of the present disclosure, as defined in the appended claim(s). Accordingly, it is intended that the present disclosure is not limited to the described embodiments, but that it has the full scope defined by the language of the following claims, and equivalents thereof.

## Claims

1. A triode for alternating current semiconductor comprising:
an N- region sandwiched between a first P region and a second P region, wherein the first P region is coupled to an MT2 terminal and the second P region is coupled to a first MT1 terminal and a second MT1 terminal;
a first plurality of N+ regions disposed within the first P region; and
a trench disposed between a first gate terminal and a second gate terminal.

2. The triode for alternating current semiconductor of claim 1, further comprising a second plurality of N+ regions disposed within the second P region.

3. The triode for alternating current semiconductor of claim 2, wherein a first N+ region of the second plurality of N+ regions is disposed beneath the first gate terminal and a second N+ region of the second plurality of N+ regions is disposed beneath the second gate terminal.

4. The triode for alternating current semiconductor of any of the claims 1-3, wherein the trench cuts through the second P region.

5. The triode for alternating current semiconductor of any of the preceding claims, wherein the trench cuts into the N- region.

6. The triode for alternating current semiconductor of any of the preceding claims, wherein current flows from the MT2 terminal to the first MT1 terminal in response to the MT2 terminal having a higher bias than the first MT1 terminal.

7. The triode for alternating current semiconductor of any of the preceding claims, wherein current flows from the second MT1 terminal to the MT2 terminal in response to the second MT1 terminal having a higher bias than the MT2 terminal.

8. The triode for alternating current semiconductor of any of the preceding claims, further comprising a first junction between the first P region and the N- region.

9. The triode for alternating current semiconductor of claim 8, further comprising a second junction between the N- region and the second P region.

10. The triode for alternating current semiconductor of claim 9, further comprising a third junction between the second P region and the second plurality of N+ regions.

11. The triode for alternating current semiconductor of claim 10, further comprising a fourth junction between the first plurality of N+ regions and the first P region.

12. The triode for alternating current semiconductor of any of the preceding claims, wherein there is no shunt current.

13. The triode for alternating current semiconductor of any of the preceding claims, wherein a first N+ region of the second plurality of N+ regions is disposed beneath the MT1 terminal, preferably wherein a second N+ region of the second plurality of N+ regions is disposed beneath the MT1 terminal, more preferably wherein a third N+ region of the second plurality of N+ regions is disposed beneath the MT1 terminal.

14. The triode for alternating current semiconductor of any of the preceding claims, wherein a first N+ region of the first plurality of N+ regions is disposed beneath the MT2 terminal, preferably wherein a second N+ region of the first plurality of N+ regions is disposed beneath the MT2 terminal.

15. The triode for alternating current semiconductor of claim 14, wherein a third N+ region of the first plurality of N+ regions is disposed beneath the MT2 terminal, preferably wherein
a fourth N+ region of the first plurality of N+ regions is disposed beneath the MT2 terminal.
